Europäisches Patentamt

European Patent Office

Office européen des brevets

(11) Publication number: **0 388 208**
**A2**

## (12) EUROPEAN PATENT APPLICATION

(21) Application number: **90302812.4**

(22) Date of filing: **15.03.90**

(51) Int. Cl.⁵: **H01L 21/00, C30B 15/30**

(30) Priority: **15.03.89 JP 61033/89**

(43) Date of publication of application:
**19.09.90 Bulletin 90/38**

(84) Designated Contracting States:
**DE FR GB**

(71) Applicant: **SHIN-ETSU HANDOTAI COMPANY, LIMITED**
**4-2, Marunouchi 1-Chome**
**Chiyoda-ku Tokyo(JP)**

(72) Inventor: **Ibe, Hiroyuki**
**41-4 Hosono, Ota-cho**
**Nyu-gun, Fukui-ken(JP)**
Inventor: **Ohtsuna, Hiroshi**
**1-8-19 Kamiuzue-cho**
**Sabae-shi, Fukui-ken(JP)**

(74) Representative: **Whalley, Kevin et al**
**MARKS & CLERK 57/60 Lincoln's Inn Fields**
**London WC2A 3LS(GB)**

(54) **Ingot removal device for a single crystal pulling apparatus.**

(57) An ingot removal device (1) for removing a single crystal ingot from an upper pull chamber (32) of a single crystal pulling apparatus consisting essentially of a support frame (40, 41), an ingot positioner (19) to position the ingot in a desired posture, clamps (17, 18, 20) which can clamp the thus positioned ingot, an arm which can shift and swing vertically and horizontally, having a vertical slider (2-4) to slide the arm vertically, a horizontal slider (6-8) to slide the arm horizontally, a horizontal swinger (9-12) to swing the arm horizontally, and a vertical swinger (13-15) to swing the arm vertically.

Fig. 1

## INGOT REMOVAL DEVICE FOR A SINGLE CRYSTAL PULLING APPARATUS

The present invention relates to an ingot removal device for removing an ingot from a single crystal pulling apparatus in which the single crystal ingot is grown and pulled up.

Single crystals such as silicon single crystal are obtained by means of the CZ method (Czochralski method). A single crystal pulling apparatus is an apparatus designed to grow and pull up a single crystal ingot from the melt of a polycrystal substance. A conventional single crystal pulling apparatus consists mainly of a main chamber, and in this chamber are provided a crucible for containing the polycrystal substance for crystallization, a heater surrounding the crucible to melt down the polycrystal substance, a thermal insulator surrounding the heater, etc. Above the main chamber is provided an upper pull chamber in which the single crystal ingot brought up from the main chamber is received.

The single crystal ingot pulled up is taken away from the upper pull chamber, and brought into a subsequent semiconductor wafer manufacturing process wherein the ingot is externally ground and sliced into wafers. However, since the single crystal ingot is a heavy substance and very hot at the time of removal from the upper pull chamber, the operation would be low in efficiency, time-consuming and quite dangerous, if the removal is carried out manually.

Thus, mechanical devices for automatically removing a single crystal ingot from the upper pull chamber have been proposed. For example, Japanese Utility Model Publication No. 47-42513 published on December 22nd, 1972 proposes a single crystal pulling apparatus which consists of a crucible to contain raw crystal substance, a means to heat the substance, a main chamber to contain the crucible, a detachable tubular body (upper pull chamber) provided above the main chamber in a manner such that the detachable tubular body is in communication with and detachable from the main chamber, a pulling means for pulling up into the detachable tubular body the ingot grown from the crystal substance in the crucible, a means for detaching the detachable tubular body from the main chamber, a turning body for pivotally shifting the detachable tubular body, which was detached by means of the detaching means and the pulling means, into a different position, and an ingot receiver provided on a base directly below the position assumed by the pivotally shifted ingot.

Another example is WO82/04074 published on November 25th, 1982 which proposes a single crystal pulling apparatus consisting of a lower melt chamber (main chamber), a crucible to contain the melt, an upper crystal chamber (upper pull chamber) to receive the grown single crystal ingot, a means to separate the upper chamber, which is hermetically sealed with the lower chamber, from the lower chamber so as to allow the upper chamber to be detached from the lower chamber, a pulling head means for lifting a seed crystal and the as-grown crystal from the melt in the lower chamber, a shifting means for shifting the upper chamber between a crystal receiving position at which the upper chamber receives the lifted crystal and a crystal release position where the lower chamber is absent, and a holder means for supporting and holding the crystal grown in the upper chamber during the removing of the upper chamber.

In the case of Japanese Utility Model Publication No. 47-42513, the device for removing the ingot from the pulling apparatus comprises the upper pull chamber which is a part of the pulling apparatus, so that in the single crystal ingot removal operation it is essential to remove the upper pull chamber (detachable tubular body) from the apparatus, which necessitates enlargement and complication of the pulling apparatus, and improvement in operation efficiency and power saving is wanted.

Similarly, in the case of WO82/04074, the device for removing the ingot from the pulling apparatus comprises the upper pull chamber which is a part of the pulling apparatus, and it is necessary to circle the upper pull chamber (upper chamber) about the rotatable hoist of the removing device in the removal operation, so that the pulling apparatus has to be enlarged and its construction complicated. Also, a cart must be specially provided to receive the single crystal ingot.

The present invention was made in view of the foregoing problem, and it is an object of the invention to provide an ingot removal device for removing an ingot from a single crystal pulling apparatus which can be provided separately from the pulling apparatus without the necessity of modifying the existing pulling apparatus, and which enables operation-efficient, time-effective, and safe ingot removal operation.

In order to attain the above and other objects of the invention, an ingot removal device is provided for removing a single crystal ingot from an upper pull chamber of a single crystal pulling apparatus in which the ingot is pulled up. This inventive ingot removal device is basically a mechanical device controllably driven by electric motors to hold and take out the ingot from the upper pull chamber of the single crystal pulling apparatus, and carry it to an arbitrary position, and place it in an arbitrary posture. Therefore, the inventive ingot removal device consists of:

a stationary frame means which is installed in a predetermined position in relation to a separately installed single crystal pulling apparatus and supports all the other elements of the ingot removal device ,

a clamp means capable of clamping a vertically suspended single crystal ingot ,

an ingot positioning means provided below the clamp means and capable of receiving and positioning the freely suspended ingot into a predetermined vertical posture such that if the ingot has an undeformed circular-conical bottom the ingot can be clamped by the clamp means without being moved thereby,

a first linear displacing means for vertically displacing the clamp means and the ingot positioning means,

a second linear displacing means for displacing the clamp means and the ingot positioning means in a horizontal direction,

a horizontally swinging means for horizontally swinging the clamp means and the ingot positioning means, and

a vertically swinging means for vertically swinging the clamp means and the ingot positioning means.

Incidentally, said predetermined position in which the stationary frame means is installed in relation to the single crystal pulling apparatus is determined such that the horizontal direction in which the clamp means and the ingot positioning means are displaced by the second linear displacing means is directly opposite the horizontal direction in which an upper pull chamber of the ingot pulling apparatus opens to allow the ingot to be taken away.

In a preferred embodiment of the invention, the clamp means comprises one or more chucks arranged in a vertical row, and more preferably, the clamp means comprises two chucks , one provided above the other, and at least the upper chuck can be shifted to adjust the distance between the two chucks.

In another preferred embodiment, the first linear displacing means consists of a pair of vertical parallel guide rails fixed on the stationary frame means and a vertical body having slider shoes slidably engaged with the guide rails .

In another preferred embodiment, the second linear displacing means consists of a pair of lateral parallel guide rails fixed on the vertical body of the first linear displacing means and a vertical body having slider shoes slidably engaged with the guide rails

In another preferred embodiment, the horizontally swinging means consists of a first horizontally swinging arm pivotally supported by the second linear displacing means and a second horizontally swinging arm pivotally supported by the first horizontally swinging arm.

In a still another preferred embodiment, the vertically swinging means consists of a vertically swinging arm pivotally supported by the horizontally swinging means.

The ingot removal device, which is kept at its uppermost position during the single crystal ingot pulling operation, is brought down to the optimum altitude for removal of the single crystal ingot from the upper pull chamber by operating the first linear displacing means. Then, the horizontally swinging means (or the first and the second horizontally swinging arms) and the second linear displacing means are operated so as to bring the clamp means and the ingot positioning means towards the ingot in the upper pull chamber of the pulling apparatus. When it is determined that the clamp means and the ingot positioning means are in the appropriate position in relation to the ingot, the ingot suspended is lowered until it is received in the ingot positioning means whereby the ingot is positioned into the predetermined posture, and then the clamp means are caused to clamp the single crystal ingot, which is held vertically thereby.

Thereafter, the second linear displacing means and the horizontally swinging means are operated again in such a manner as to bring the single crystal ingot into a predetermined position, and then the vertically swinging means is operated to swing through an angle of $90°$ such that the clamp means and the ingot positioning means are swung therewith to bring the clamped ingot into a horizontal posture, which is such that the ingot is placed on a transfer cart. Next, when the clamp means and the ingot positioning means are operated to stop clamping and keeping the ingot, the ingot is alighted on the transfer cart, which carries it away. Thus, with the inventive ingot removal device, it is possible to remove the hot and heavy single crystal ingot from the ingot pulling apparatus, and bring it onto the transfer cart without using any human labor except for the controlling of the device. Thus, the operation effectiveness, the time efficiency as well as the safety of the single crystal ingot removal operation is improved. Furthermore, since the inventive device is installed separately from the pulling apparatus, it is not necessary to modify the existing pulling apparatuses, and therefore, no enlargement or complication of them is required.

Further scope of applicability of the present invention will become apparent from the detailed description given hereafter. However, it should be understood that the detailed description and specific example, while indicating a preferred embodiment of the invention, is given by way of illustration only, since various changes and modifications within the spirit and scope of the invention will become apparent to those skilled in the art from this detailed description.

The present invention will become more fully understood from the detailed description given hereinbelow and the accompanying drawings which are given by way of illustration only, and thus are not limitative of the present invention and wherein:

Fig. 1 is a side view of a single crystal removal device according to the invention;

Fig. 2 is a top plan view of the same device;

Fig. 3 is a flowchart showing the procedure for a single crystal ingot removing operation;

Fig. 4 is a top plan view of the single crystal removal device showing a step in the single crystal ingot removing operation;

Fig. 5 is a view similar to Fig. 4 showing a different step;

Fig. 6 is a view similar to Fig. 4 showing a different step;

Fig. 7 is a view similar to Fig. 4 showing a different step;

Fig. 8 is a view similar to Fig. 4 showing a different step;

Fig. 9 is a view similar to Fig. 4 showing a different step;

Fig. 10 is a view similar to Fig. 4 showing a different step;

Fig. 11 is a view similar to Fig. 4 showing a different step; and

Fig. 12 is a side view of a single crystal removal device and a transfer cart showing a step in the single crystal ingot removing operation.

An embodiment of the invention will be described with reference to attached drawings.

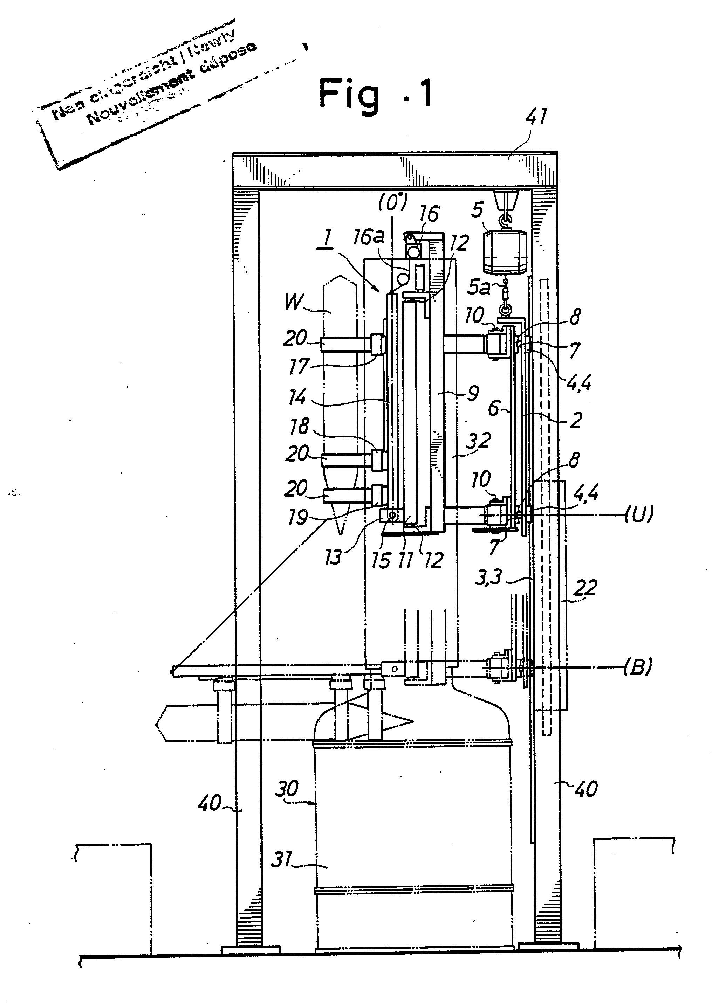

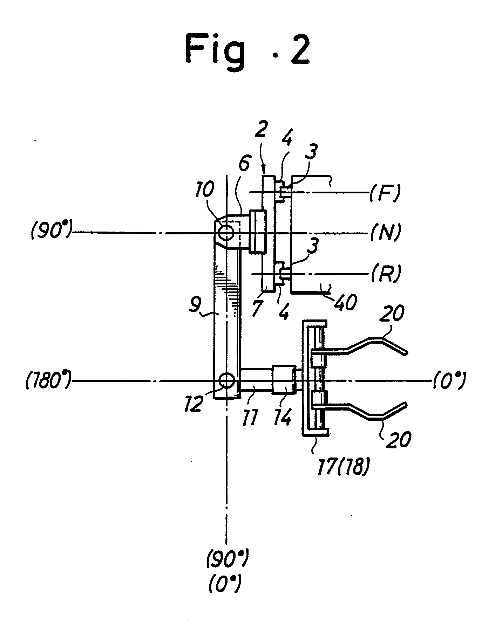

Fig. 1 is a side view of a single crystal removal device according to the invention, and Fig. 2 is a top plan view of the same device. In Fig. 1 reference numeral 30 designates a single crystal pulling apparatus, which mainly consists of a main chamber 31 and an upper pull chamber 32 provided above the main chamber 31, and inside the main chamber 31 are a crucible, heater, a heat insulator, etc., which are not shown. This single crystal pulling apparatus 30 is an apparatus designed to pull up a single crystal ingot based on the CZ method which comprises the steps of charging the crucible in the main chamber 31 with a polycrystal substance such as silicon, heating and fusing the polycrystal substance with the heater, dipping a seed crystal suspended from above into the polycrystal melt, raising the seed crystal as it is rotated, and thus pulling up the desired single crystal ingot, which is lifted up into the upper pull chamber 32.

A pair of pole braces 40 are planted in the vicinity of the single crystal pulling apparatus 30. A single crystal ingot removal device 1, which forms a separate body from the pulling apparatus 30, is supported by one of the pole braces in a manner such that the device 1 can slide vertically along the pole brace 40. In particular, said one of the pole braces 40 has a pair of parallel guide rails 3 fixedly laid on it to extend vertically, and the single crystal ingot removal device 1 has an elevation base 2 which is provided with four slider shoes 4, which 4 are slidably engaged with the guide rails 3. The elevation base 2, which is a vertical rectangular plate with the upper end folded to form a horizontal portion, is hung by a chain 5a which is unreeled from an electric chain block 5 and connected to the horizontal portion of the elevation base 2. The chain block 5 is hung from a horizontal beam 41 which is fixed on top of the pole braces 40. Therefore, the ingot removal device 1 is capable of moving vertically along the pole brace 40 as the chain 5a is reeled in or unreeled.

A sideway base 6 is supported by the elevation base 2 in a manner such that the sideway base 6 can slide laterally through the breadth of the elevation base 2 so that the ingot removal device 1 can horizontally approach or withdraw from the pulling apparatus 30. In particular, the elevation base 2 has a pair of parallel guide rails 7 fixedly laid on it to extend laterally, and the sideway base 6 is provided with a pair of slider shoes 8, which 8 are slidably engaged with the guide rails 7. The sideway base 6 is caused to move on the guide rails 7 by means of a rack and pinion mechanism which is driven by an electric motor, not shown. Therefore, the ingot removal device 1 is capable of moving horizontally.

The sideway base 6 is provided with a first arm 9, which is pivotally hinged at its two joint bases by a pair of vertical shafts 10. This first arm 9 is caused to turn horizontally about the shafts 10 through an angle of 90° by means of a drive mechanism driven by an electric motor, not shown.

A vertical shaft 12 is provided at the end of the first arm 9, and a second arm 11 is pivotally hinged at its joint base by the shaft 12 such that the second arm 11 can turn horizontally about the shaft 12 provided. A bracket 13 is provided at the lower end of the second arm 11 and has a horizontal shaft 15 which provides a fulcrum for a swing arm 14. The second arm in can be caused to turn horizontally about the shaft 12 through a maximum angle of 180° by means of a drive mechanism driven by an electric motor, not shown.

The swing arm 14 is capable of vertically swinging about the shaft 15 of the bracket 13, and has its upper end connected to the end of a chain 16a which is unreeled from an electric chain block 16 provided at the upper end portion of the first arm 9. The swing arm 14 is provided with a first chuck 17, a second chuck 18, and a third chuck 19, which extend horizontally from the swing arm 14. The first and second chucks 17, 18 are for seizing a single crystal ingot W, and the third chuck 19 is for centering the ingot W, as shown in Fig. 1. Incidentally, each of these first, second, and third chucks is provided with a pair of hands 20 which are adapted to move horizontally by means of screw mechanism driven by an electric motor, not shown, such that the distance between the hands 20 is either reduced or increased (ref. Fig. 2). The first chuck 17 is also adapted to be able to move vertically along the length of the swing arm 14 by means of a screw mechanism driven by an electric motor, not shown. The first and second chucks 17, 18 each are provided with a sensor for detecting whether or not the ingot W exists between the hands 20, and a torque limiter which is adapted to prevent the hands 20 from over pressing and damaging the ingot W.

While the single crystal is being pulled up in the single crystal pulling apparatus 30, the single crystal ingot removal device 1 stands by in its stand-by position. When in the stand-by position, the ingot removal device 1 keeps its elevation base 2 in the uppermost position (U) as drawn in the solid line in Fig. 1, its sideway base 6 in the neutral position as indicated by the line (N), the first arm 9 and the second arm 11 in the respective 0° positions as shown in Fig. 2, the swing arm 14 in the 0° position (vertical position) as drawn in solid line in Fig. 1, and the first, second, and third chucks 17, 18, 19 are in the open positions. Incidentally, reference numeral 22 in Fig. 1 designates a console panel which is supported by the pole brace 40.

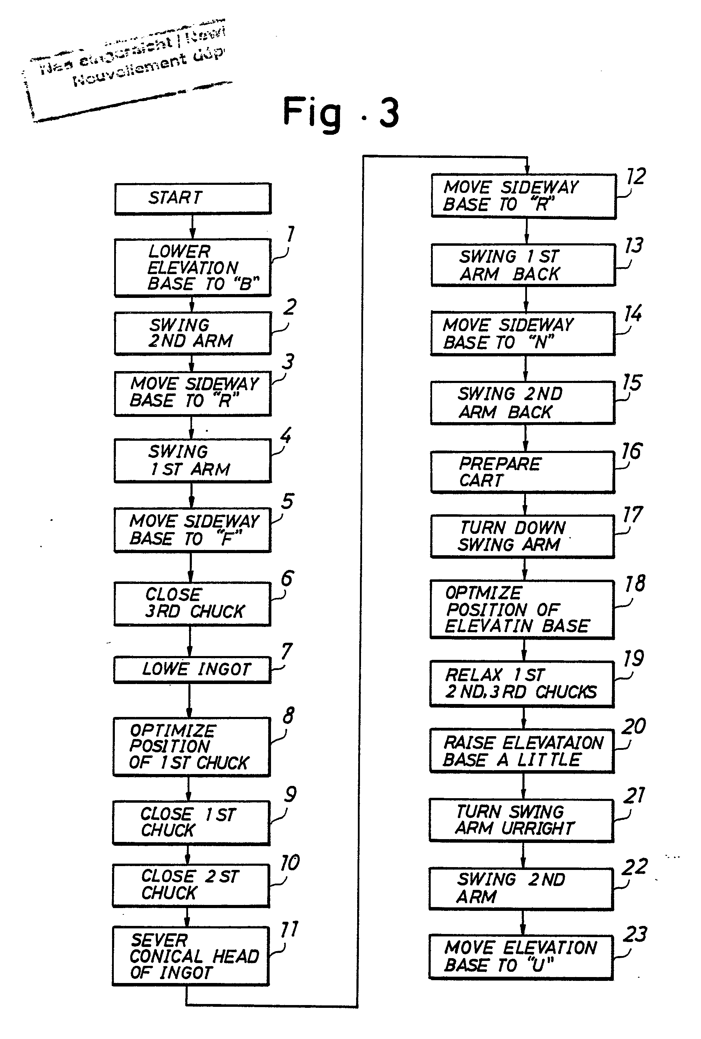

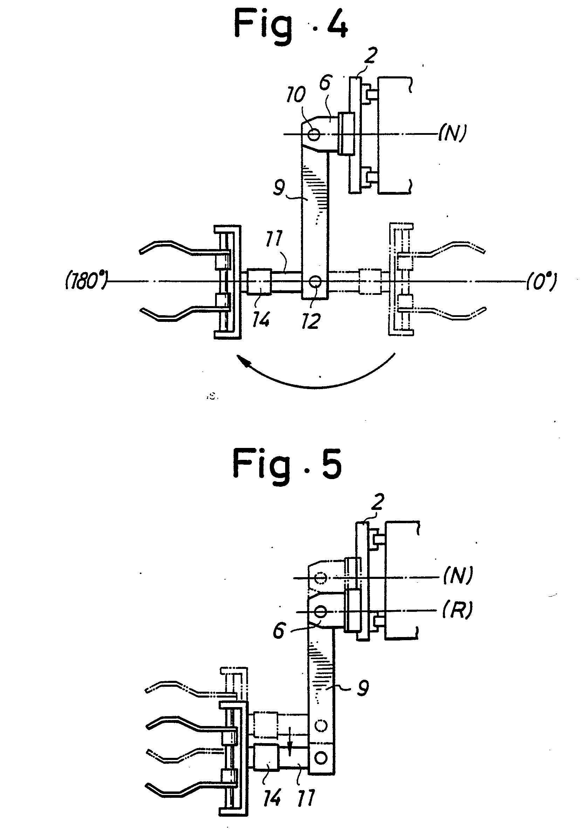

Next, the removal operation of the single crystal ingot W by means of the single crystal ingot removal device 1 will be described with reference to the flowchart of Fig. 3 and other drawings Figs. 4 through 12 descriptive of the ingot removal operation.

First, it is determined whether or not the single crystal ingot W has been completely pulled up and brought into the upper pull chamber 32, and if it is found that the ingot W is ready in the upper pull chamber 32, the ingot removal operation is started (START). Thereupon, the console panel 22 is worked on in a manner such that the electric chain block 5 is driven to unreel the chain 5a to thereby lower the elevation base 2 from the uppermost position (U) along the guide rails 3 until the elevation base 2 assumes its lowermost position (B) as drawn in two-dot chain line in Fig. 1 (step 1 of Fig. 3). Next, the second arm 11 is caused to turn horizontally about the shaft 12 through an angle of 180° from the 0° position, as shown in Fig. 4 (step 2). The sideway base 6 is caused to move into the rear position (R), as shown in Fig. 5 (step 3).

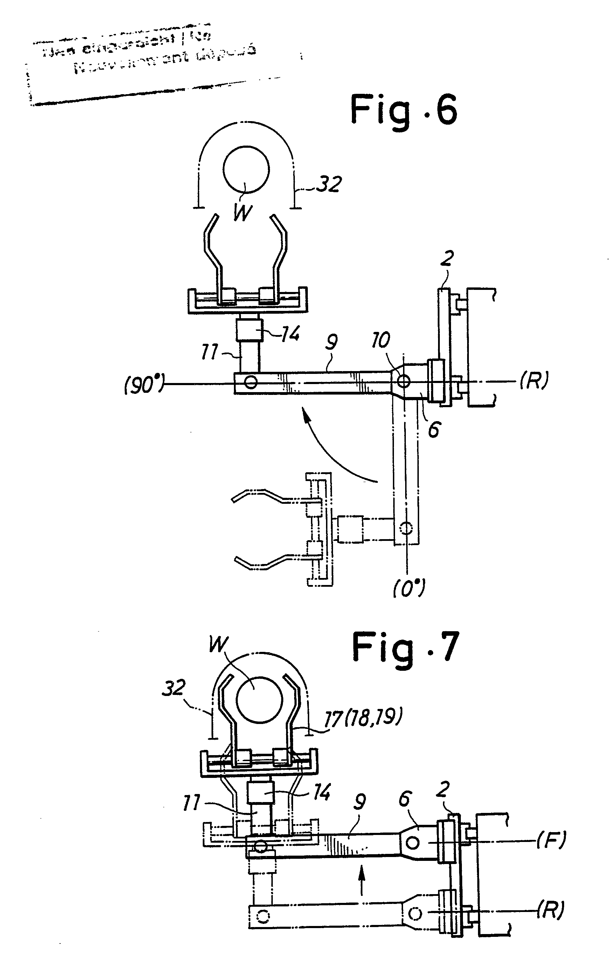

Next, as shown in Fig. 6, the first arm 9 is caused to turn horizontally about the shafts 10 through an angle of 90° from the 0° position (step 4), and the sideway base 6 is caused to move into the forward position (F), as shown in Fig. 7 (step 5), whereby the hands 20 of the first, second and third chucks 17, 18, 19 are caused to enter the upper pull chamber 32 whose open-close door has been opened beforehand. Incidentally, the circular body designated by W in Figs. 6, 7, and so on is a top plan view of the single crystal ingot.

So far the ingot removal preparation steps have been described. Next, the actual removal operation steps will be explained.

The third chuck 19 for centering the ingot is operated to close the hands 20 (step 6), and then the single crystal ingot W is lowered (step 7) whereby the single crystal ingot W is centered by means of the third chuck 19.

Thereafter, the first chuck 17 is caused to move vertically along the length of the swing arm 14 to assume the optimum position in relation to the length of the as-grown single crystal ingot (step 8). When the sensor provided at the first chuck 17 detects the presence of the ingot W, the first chuck 17 is caused to close its hands 20 whereby the single crystal ingot W is seized (step 9). Incidentally, the magnitude of the force with which the ingot W is seized by the first chuck 17 is limited to a predetermined value by means of the torque limiter provided at the first chuck 17.

Similarly as above, when the sensor provided at the second chuck 18 detects the presence of the ingot W, the second chuck 18 is caused to close its hands 20 to thereby seize the single crystal ingot W (step 10). Thus, the single crystal ingot W is centered by the third chuck 19 and seized by the first and second chucks 17, 18, whereafter the conical head portion of the ingot W is severed off (step 11).

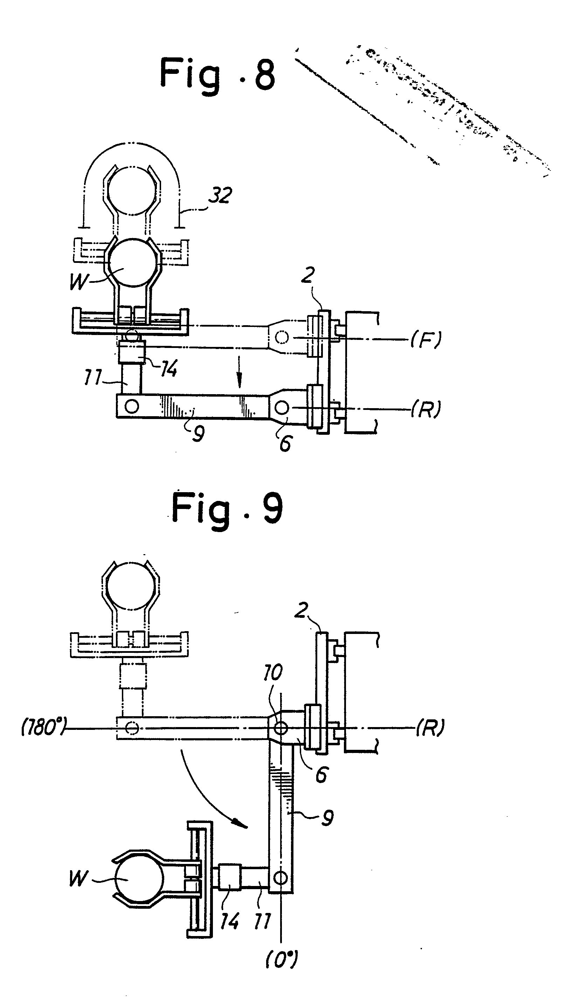

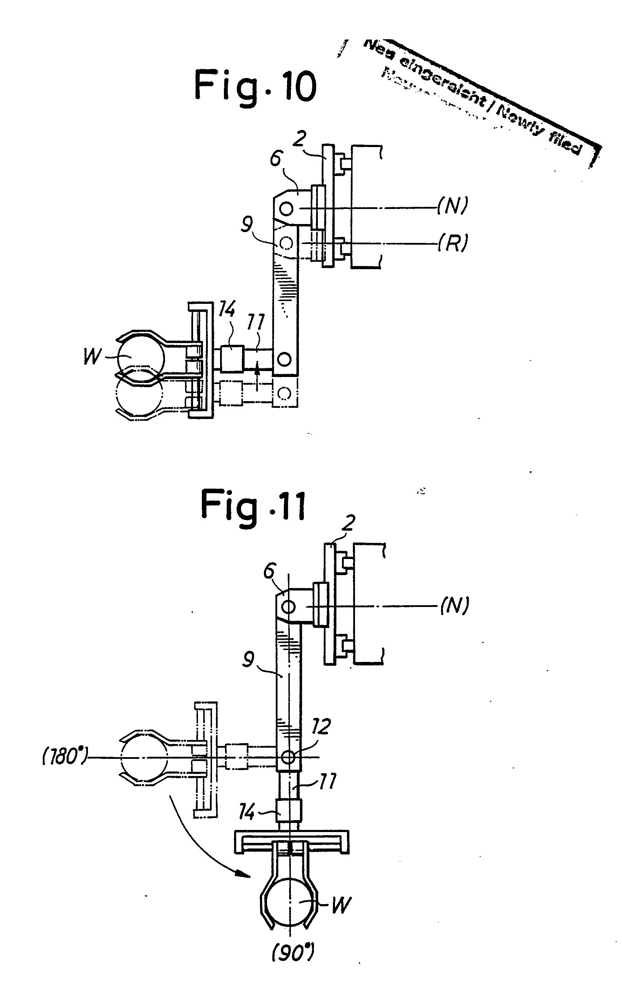

Next, the sideway base 6 is caused to move back into the rear position (R) as shown in Fig. 8 (step 12), and then the first arm 9 is caused to swing back into the original 0° position by horizontally turning through an angle of 90° about the shafts 10 as shown in Fig. 9 (step 13). Then, the sideway base 6 is caused to move forward into the neutral position (N) as shown in Fig. 10 (step 14), and the second arm 11 is horizontally turned backward about the shaft 12 through an angle of 90° as shown in Fig. 11 (step 15), whereby the first and the second arms 9, 11 become collinear with each other, and the removal operation of the single crystal ingot W is complete.

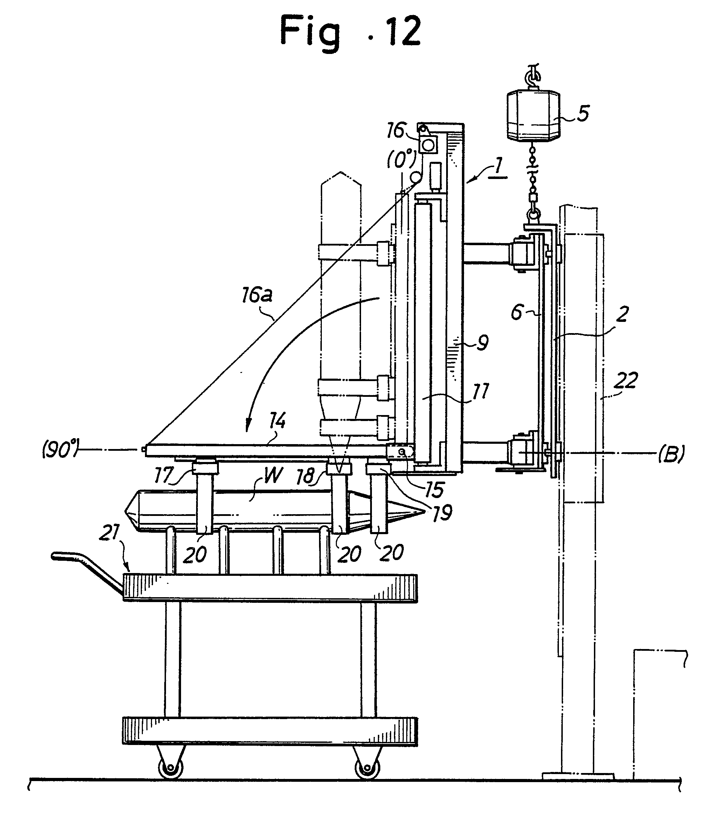

When the ingot removal operation is completed as described above, a transfer cart 21 is brought into the position it is assuming in Fig. 12 (step 16), and the electric chain block 16 is driven to unreel as much chain 16a as the swing arm 14 is caused to turn downward through 90° about the shaft 15 (step 17), whereby the single crystal ingot W carried by the swing arm 14 turns to dispose horizontally over the transfer cart 21, as shown in Fig. 12. Then, the electric chain block 5 is driven to cause the elevation base 2 to descend slowly so as to bring the ingot W to alight on the transfer cart 21 (step 18). Next, the first, second, and third chucks 17, 18, 19 are caused to relax the hands 20 (step 19) whereupon the ingot W is released from the ingot removal device 1 and mounted on the transfer cart 21.

When the conveyance of the single crystal ingot W onto the transfer cart 21 has been thus completed, the electric chain block 5 is driven to reel in the chain 5a to pull up the elevation base 2 to an extent that the chucks 17, 18, 19 do not interfere with the ingot W (step 20), and then the electric chain block 16 is driven to reel in as much chain 16a as the swing arm 14 is caused to turn upward through 90° about the shaft 15 to assume the original vertical position (step 21). The second arm 11 is horizontally turned counterclockwise, as viewed in Fig. 11, about the shaft 12 through an angle of 90° (step 22) and finally the elevation base 2 is caused to ascend to the uppermost position (U) (step 23) whereupon the ingot removal device assumes the original posture of Fig. 2.

Now, as described above, if the single crystal ingot removal device 1 is employed, it is possible to take out the heavy, hot single crystal ingot W from the upper pull chamber 32 and convey it on the transfer cart 21 effectively and safely in a relatively short time. Also, since the single crystal ingot removal device 1 is installed separately from the ingot pulling apparatus 30, there is no need of modifying the existing pulling apparatus 30 and thus the pulling apparatus 30 need not have increased size or more complicated construction.

## Claims

1. An ingot removal device for removing a single crystal ingot from an upper pull chamber (32) of a single crystal pulling apparatus comprising:
a stationary frame means (40, 41) which is installed in a predetermined position in relation to the separately installed single crystal pulling apparatus (30) and supports all the other elements of the ingot removal device (1),
a clamp means (17, 18, 20) capable of clamping the vertically suspended single crystal ingot (W),
an ingot positioning means (19) provided below the clamp means and capable of receiving and positioning the freely suspended ingot (W) into a predetermined vertical posture such that if the ingot has an undeformed circular-conical bottom the ingot can be clamped by the clamp means (17, 18) without being moved thereby,
a first linear displacing means (2, 3, 4) for vertically displacing the clamp means and the ingot positioning means,
a second linear displacing means (6, 7, 8) for displacing the clamp means and the ingot positioning means in a horizontal direction,
a horizontally swinging means (9, 10, 11, 12) for horizontally swinging the clamp means and the ingot positioning means, and
a vertically swinging means (13, 14, 15) for vertically swinging the clamp means and the ingot positioning means.

2. An ingot removal device of claim 1, wherein the clamp means comprises one or more chucks arranged in a vertical row;
the first linear displacing means consists of a pair of vertical parallel guide rails (3) fixed on the stationary frame means (40) and a vertical body (2) having slider shoes (4) slidably engaged with the guide rails (3);
the second linear displacing means consists of a pair of lateral parallel guide rails (7) fixed on the vertical body (2) of the first linear displacing means and a vertical body (6) having slider shoes (8) slidably engaged with the guide rails (7);
the horizontally swinging means consists of a first horizontally swinging arm (9) pivotally supported by the second linear displacing means and a second horizontally swinging arm (11) pivotally supported by the first horizontally swinging arm; and
the vertically swinging means consists of a vertically swinging arm (14) pivotally supported by the horizontally swinging means.

3. An ingot removal device of claim 2 wherein the clamp means comprises two chucks (17, 18), and at least the upper chuck (17) can be displaced to adjust the distance between the two chucks.

4. An ingot removal device of claim 2 wherein at least one chuck is adapted to detect whether or not an ingot exists in a predetermined position in relation thereto.

5. An ingot removal device of claim 2, wherein all of the chucks are adapted to restrict their clamping force to a predetermined magnitude.

6. An ingot removal device of claim 2 wherein the vertically swinging arm is adapted to swing through an angle of 90° from a vertical position to a horizontal position and vice versa.

7. An ingot removal device of claim 2 wherein the clamp means comprises two chucks (17, 18), and at least the upper chuck (17) can be displaced to adjust the distance between the two chucks;
at least one chuck is adapted to detect whether or not an ingot exists in a predetermined position in relation thereto;

all of the chucks are adapted to restrict their clamping force to a predetermined magnitude; and the vertically swinging arm is adapted to swing through an angle of 90° from a vertical position to a horizontal position and vice versa.

8. An ingot removal device of claim 7 for which the source of the drive force is electromotive.

# Fig ·1

# Fig . 2

# Fig . 3

```
START
  │
  ▼
LOWER
ELEVATION          ─ 1
BASE TO "B"
  │
  ▼
SWING              ─ 2
2ND ARM
  │
  ▼
MOVE SIDEWAY       ─ 3
BASE TO "R"
  │
  ▼
SWING              ─ 4
1ST ARM
  │
  ▼
MOVE SIDEWAY       ─ 5
BASE TO "F"
  │
  ▼
CLOSE              ─ 6
3RD CHUCK
  │
  ▼
LOWE INGOT         ─ 7
  │
  ▼
OPTIMIZE
POSITION           ─ 8
OF 1ST CHUCK
  │
  ▼
CLOSE 1ST          ─ 9
CHUCK
  │
  ▼
CLOSE 2ST          ─ 10
CHUCK
  │
  ▼
SEVER
CONICAL HEAD       ─ 11
OF INGOT
```

```
MOVE SIDEWAY       ─ 12
BASE TO "R"
  │
  ▼
SWING 1ST          ─ 13
ARM  BACK
  │
  ▼
MOVE SIDEWAY       ─ 14
BASE TO "N"
  │
  ▼
SWING 2ND          ─ 15
ARM  BACK
  │
  ▼
PREPARE            ─ 16
CART
  │
  ▼
TURN DOWN          ─ 17
SWING ARM
  │
  ▼
OPTMIZE
POSITION OF        ─ 18
ELEVATIN BASE
  │
  ▼
RELAX 1ST          ─ 19
2ND,3RD CHUCKS
  │
  ▼
RAISE ELEVATAION   ─ 20
BASE A LITTLE
  │
  ▼
TURN SWING         ─ 21
ARM URRIGHT
  │
  ▼
SWING 2ND          ─ 22
ARM
  │
  ▼
MOVE ELEVATION     ─ 23
BASE TO "U"
```

## Fig . 4

## Fig . 5

# Fig ·6

# Fig ·7

# Fig.8

# Fig.9

# Fig.10

2

6

(N)

9

(R)

14

11

W

# Fig.11

2

6

(N)

9

12

(180°)

11

14

W

(90°)

# Fig .12